# FASCICULE DE BREVET EUROPEEN

(11) **EP 1 062 852 B1**
(45) Date de publication et mention de la délivrance du brevet: **05.06.2002**
(21) Numéro de dépôt: 99904927.3
(22) Date de dépôt: 22.02.1999
(51) Int. Cl.: H05K 7/20

(54) **ELEMENT DE REFROIDISSEMENT POUR DISPOSITIF ELECTRONIQUE DE PUISSANCE ET DISPOSITIF ELECTRONIQUE DE PUISSANCE COMPRENANT UN TEL ELEMENT**
KÜHLELEMENT FÜR EINE ELEKTRONISCHE LEISTUNGSVORRICHTUNG UND EINE ELEKTRONISCHE LEISTUNGSVORRICHTUNG MIT EINEM SOLCHEN ELEMENT
COOLING ELEMENT FOR ELECTRONIC POWER DEVICE AND POWER ELECTRONIC DEVICE COMPRISING SAME

(30) Priorité: 23.02.1998 FR 9802142
(43) Date de publication de la demande: 27.12.2000
(73) Titulaire: Alstom Transport S.A., 75116 Paris (FR)
(72) Inventeur: REGNIER, Bernard, F-73100 AIX LES BAINS (FR); CETTOUR-ROSE, Jacques, F-65320 Bordères sur l'Echez (FR); LUSCHER, Patrick, F-38540 Heyrieux (FR); FELLMANN, Daniel, F-65420 Ibos (FR)
(74) Mandataire: Gosse, Michel
(86) Numéro de dépôt international: FR9900394
(87) Numéro de publication internationale: WO9943190

(56) Documents cités:
- EP-A- 0 677 916
- FR-A- 2 607 911
- FR-A- 2 715 773
- US-A- 5 453 911

## Description

La présente invention concerne un élément de refroidissement pour composant électronique de puissance; cf. par ex. FR-A-2 715 773.

De manière habituelle, de tels éléments de refroidissement sont réalisés en métal, notamment en aluminium ou en cuivre, et comprennent un volume de circulation d'un fluide caloporteur dont les deux extrémités constituent respectivement l'entrée et la sortie de ce fluide. Les parois définissant ce volume de circulation peuvent être pourvues d'ailettes refroidies au moyen d'une circulation d'air par convection forcée ou naturelle. Ce volume de circulation peut également être alimenté en eau ou en tout autre liquide réfrigérant.

Des modules électroniques de puissance sont fixés sur cet élément de refroidissement métallique, par exemple par boulonnage. On rapporte également d'autres unités permettant le bon fonctionnement du composant électronique de puissance, comme par exemple des allumeurs, des condensateurs et une ou plusieurs barres de phase dans le cas d'une phase d'onduleur.

Les éléments de refroidissement évoqués ci-dessus présentent cependant un certain nombre d'inconvénients. En effet, il est nécessaire d'isoler électriquement entre elles la plupart des unités constitutives du composant de puissance, de sorte que l'on doit faire appel à des montages mécaniques complexes. Dans le cas d'une phase d'onduleur, des pièces isolantes sont par exemple utilisées pour la fixation des condensateurs, des allumeurs et de la ou des barres de phases. Il faut en outre éloigner de l'élément de refroidissement métallique les constituants portés à un certain potentiel.

L'emploi de ces montages mécaniques induit donc une complexité importante de l'ensemble du composant électronique de puissance, ce qui contribue à en augmenter le coût volume global et la masse de tels composants de puissance sont en outre relativement élevés.

L'invention se propose donc de réaliser un élément de refroidissement permettant de pallier les inconvénients de l'art antérieur évoqué ci-dessus. A cet effet, elle a pour objet un élément de refroidissement pour dispositif électronique, notamment pour phase d'onduleur, cet élément comprenant des moyens d'amenée et d'évacuation d'un fluide caloporteur et un volume intérieur de circulation dudit fluide, caractérisé en ce que cet élément est réalisé en un matériau électriquement isolant, et comprend au moins une ouverture mettant en communication ledit volume intérieur avec l'extérieur dudit élément, un pourtour de ladite au moins une ouverture formant siège de réception, avec interposition de moyens d'étanchéité, d'au moins une embase dudit dispositif électronique de puissance à refroidir.

Selon d'autres caractéristiques de l'invention :
- l'élément de refroidissement est réalisé en un matériau moulable ;
- l'élément de refroidissement comprend deux demi-corps identiques assemblés l'un à l'autre ;
- l'élément de refroidissement comporte un nombre d'ouvertures correspondant au nombre d'embases reçues sur cet élément ;
- l'espace intermédiaire séparant deux ouvertures voisines placées dans la direction. d'écoulement du fluide comporte au moins deux canaux s'étendant le long de cette direction, ces canaux étant séparés par au moins une nervure dont est pourvu l'élément de refroidissement ; et
- l'axe longitudinal de cette nervure est incliné par rapport à la direction d'écoulement du fluide.

L'invention a également pour objet un dispositif électronique de puissance, notamment une phase d'onduleur, comprenant un élément de refroidissement, plusieurs modules de puissance fixés sur cet élément de refroidissement et des fonctions complémentaires de ce dispositif, notamment des allumeurs, caractérisé en ce que l'élément de refroidissement est tel que décrit ci-dessus.

Selon d'autres caractéristiques de l'invention :
- chaque embase reçue sur le pourtour de ladite au moins une ouverture est réalisée de manière monobloc avec un desdits modules de puissance ;
- cette embase comporte des ailettes s'étendant selon la direction d'écoulement du flux ;
- s'agissant de modules fixés par paires, au niveau d'ouvertures correspondantes disposées de façon symétrique par rapport au plan médian de l'élément de refroidissement, un insert est bloqué entre les extrémités voisines de chaque paire de modules se faisant face, ou bien l'extrémité d'un premier module s'étend, en direction d'un second module lui faisant face, au niveau ou au-delà de l'extrémité de ce dernier ;
- les modules de puissance sont fixés sur l'élément de refroidissement par un organe de bridage, au niveau de leur face opposée au volume intérieur de circulation du fluide ;
- l'organe de bridage est électriquement conducteur et se trouve commun à deux modules de puissance voisins, disposés selon la direction d'écoulement du fluide ;
- s'agissant d'un élément de refroidissement comprenant deux demi-corps assemblés l'un à l'autre, l'organe de bridage est fixé à cet élément de refroidissement par des moyens de fixation assurant également l'assujettissement mutuel de ces deux demi-corps ;
- l'embase comprend au moins une plaque rapportée au niveau de ladite au moins une ouverture dont est pourvu ledit élément de refroidissement.

L'invention va être décrite ci-dessous, en référence aux dessins annexés, donnés uniquement à titre d'exemples non limitatifs et dans lesquels :
- la figure 1 est une vue en perspective de deux demi-corps permettant la réalisation d'un élément de refroidissement conforme à l'invention, avant assemblage de ces deux demi-corps ;
- les figures 2 et 3 sont des vues en coupe selon les lignes respectivement II-II et III-III à la figure 1, une fois l'élément de refroidissement assemblé ;
- la figure 4 est une vue en perspective d'une phase d'onduleur réalisée à partir de l'élément de refroidissement de la figure 1 une fois assemblé ;
- la figure 5 est une vue en coupe selon la ligne V-V à la figure 4 ;
- la figure 6 est une vue en coupe partielle à plus grande échelle, analogue à la figure 5, illustrant une variante de réalisation des ailettes d'un module de puissance équipant la phase d'onduleur représentée à la figure 4, et
- la figure 7 est une vue schématique partielle de dessus, illustrant le montage de deux modules de puissance successifs équipant la phase d'onduleur de la figure 4.

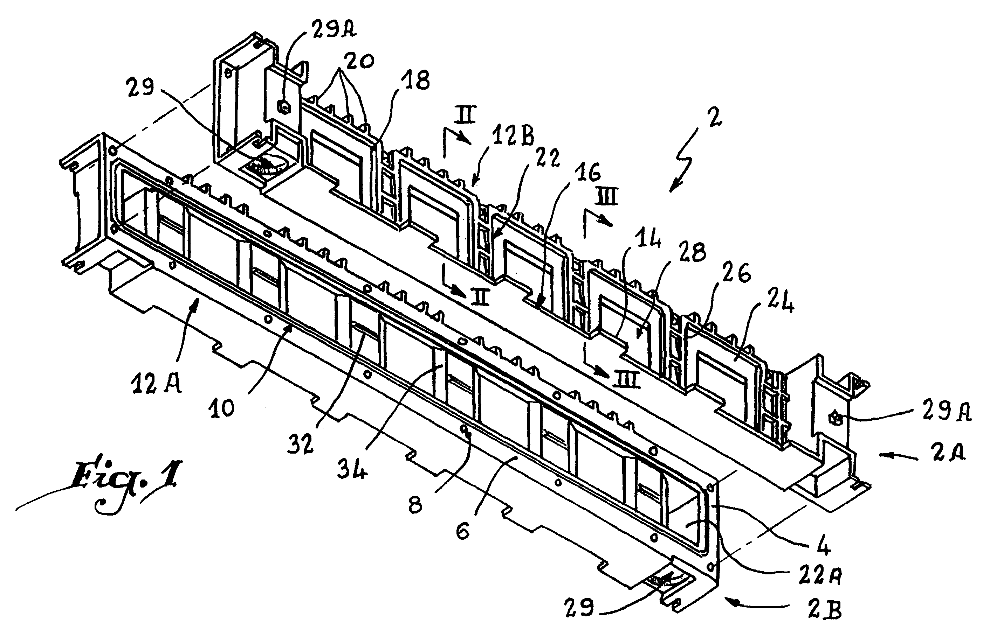

En faisant référence aux figures 1 à 3, l'élément de refroidissement conforme à l'invention, désigné dans son ensemble par la référence 2, est constitué par deux demi-corps 2A et 2B réalisés en un matériau moulable électriquement isolant, par exemple en résine moulable par injection, de type oxyde de polyphénylène (PPO). Ces demi-corps sont sensiblement identiques.

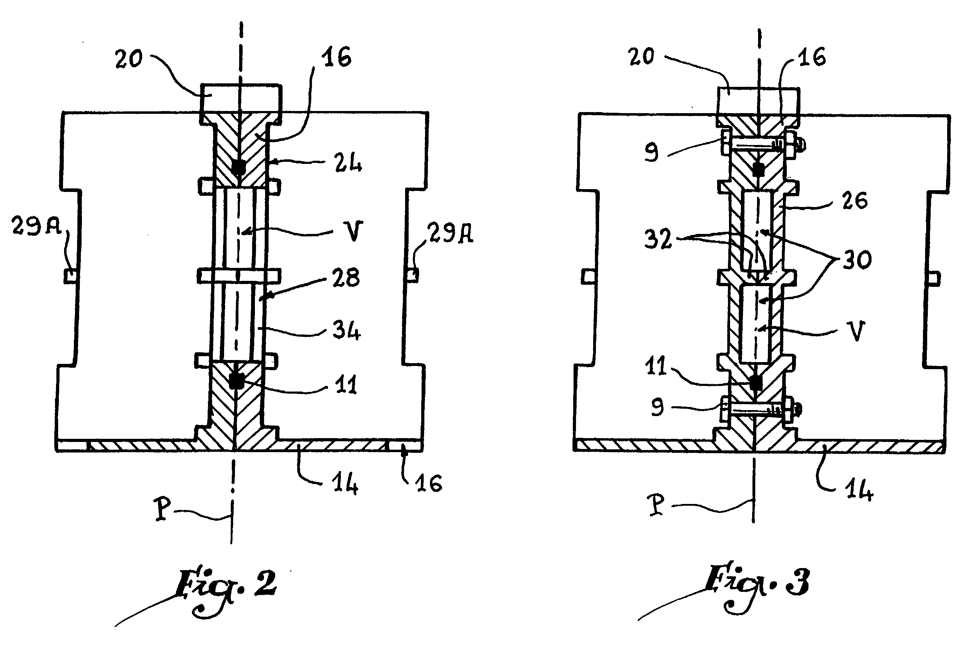

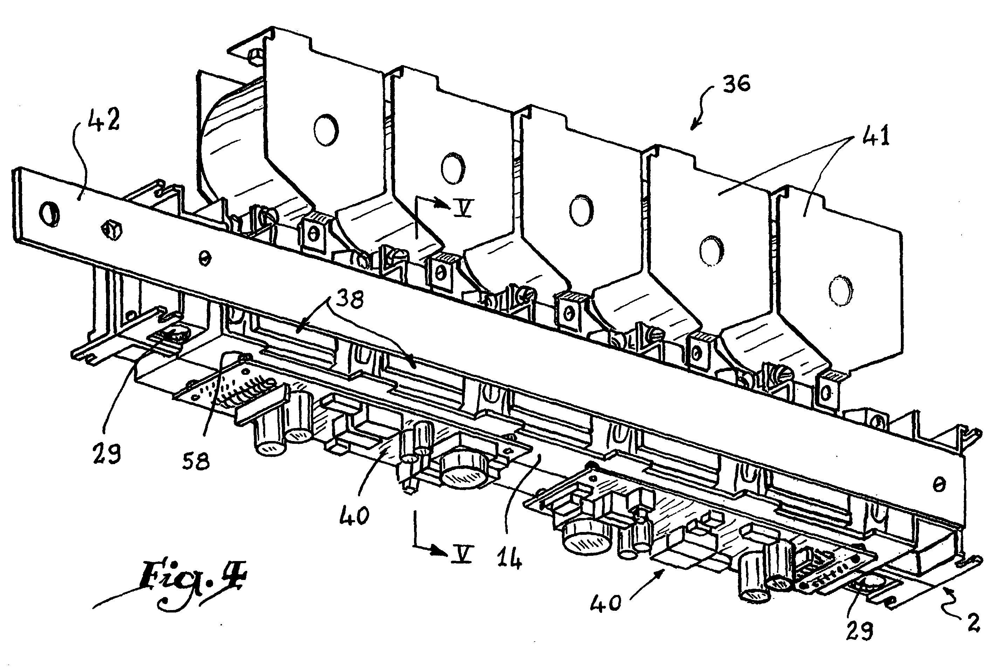

Chaque demi-corps 2A, 2B présente une forme générale globalement allongée et il comprend un fond 4 creusé sur la majeure partie de sa surface, de manière à définir une bande périphérique 6 entourant cette partie. Cette bande 6 est pourvue de plusieurs trous 8 pour le passage de vis 9 destinées à l'assemblage des deux demi-corps et représentées à la figure 3. Une gorge périphérique 10, destinée à la réception d'un joint d'étanchéité 11 visible aux figures 2 et 3, est en outre ménagée au niveau de cette bande 6.

Les cavités pratiquées dans les fonds respectifs des deux demi-corps en regard permettent de définir, au sein de l'élément de refroidissement 2 une fois assemblé, un volume de circulation V d'un fluide caloporteur, comme cela est en particulier visible sur les figures 2 et 3.

Deux parois latérales 12A et 12B s'étendent à partir de la bande périphérique 6. L'une 12A de ces parois présente un rebord longitudinal 14 continu, pourvu d'une succession d'encoches 16 destinées au passage de la commande de la phase d'onduleur une fois assemblée. L'autre paroi latérale 12B possède une bordure 18 discontinue à partir de laquelle s'étendent transversalement une multiplicité de saillies 20 destinées au logement d'entretoises, en vue de la connexion de modules de puissance équipant la phase d'onduleur une fois assemblée.

Les parois latérales 12A, 12B de chaque demi-corps sont reliées entre elles par une face 22 opposée à son fond 4. Cette face 22 comporte une série de plages 24 disposées entre le rebord 14 de la paroi latérale 12A et la bordure 18 de la paroi latérale 12B, selon l'axe principal de chaque demi-corps 2A, 2B. Deux plages consécutives sont séparées par des cloisons 26 au niveau desquelles débouchent les trous 8 de passage des vis. Une ouverture 28, destinée à la réception d'un module de puissance, est ménagée au centre de chaque plage 24. La présence de ces ouvertures 28 met en communication le volume de circulation V avec l'extérieur de l'élément de refroidissement 2.

La face 22 opposée au fond 4 forme, à chaque extrémité longitudinale de chaque demi-corps 2A, 2B, un renfoncement 22A, de sorte que l'élément de refroidissement 2 une fois assemblé possède deux espaces d'arrivée et de sortie de fluide caloporteur, à chacune de ses extrémités. Ces espaces sont en relation avec l'extérieur par des orifices respectifs 29, destinés à être mis en communication avec des lignes respectives d'arrivée et d'évacuation de ce fluide. Des pions 29A font en outre saillie vers l'extérieur à partir de chacune des extrémités de la paroi 22, et sont destinés à la fixation d'une barre de phase, comme cela sera explicité dans ce qui suit.

Comme le montre la figure 3, au sein de l'espace intermédiaire séparant deux ouvertures successives, le volume de circulation V, défini par les cloisons 26 en regard et les parois latérales 12, n'est pas en communication avec l'extérieur dé l'élément de refroidissement. Ce volume V est formé par deux canaux 30 s'étendant selon la direction d'écoulement du fluide. Ces canaux sont séparés l'un de l'autre par des nervures 32 faisant saillie à partir des cloisons 26, en direction du fond 4. Ces nervures 32 sont en contact mutuel une fois l'élément de refroidissement monté, ce qui confère alors une tenue mécanique satisfaisante à l'élément de refroidissement 2.

On peut également prévoir que l'axe longitudinal de chaque nervure soit incliné par rapport à la direction d'écoulement du fluide. Ceci permet alors l'établissement d'un écoulement agité de fluide entre deux ouvertures 28 successives, ce qui a pour avantage de mélanger des veines d'eau de températures différentes. Ceci est particulièrement sensible dans le cas où les nervures 32 ne sont pas en contact mutuel, ce qui permet au fluide de passer d'un canal à l'autre. L'extrémité axiale de chaque canal se raccorde à la plage 24 qui lui est adjacente par un plan 34 incliné à l'opposé de l'embase 4 et en direction de chaque ouverture 28, plan incliné qui est visible aux figures 1 et 2.

Dans l'exemple représenté, les deux demi-corps 2A, 2B sont mutuellement assujettis au moyen de vis et d'un joint d'étanchéité. On peut prévoir d'autres modes de fixation, tels que le collage, l'encliquetage élastique ou bien encore la soudure par ultra-sons.

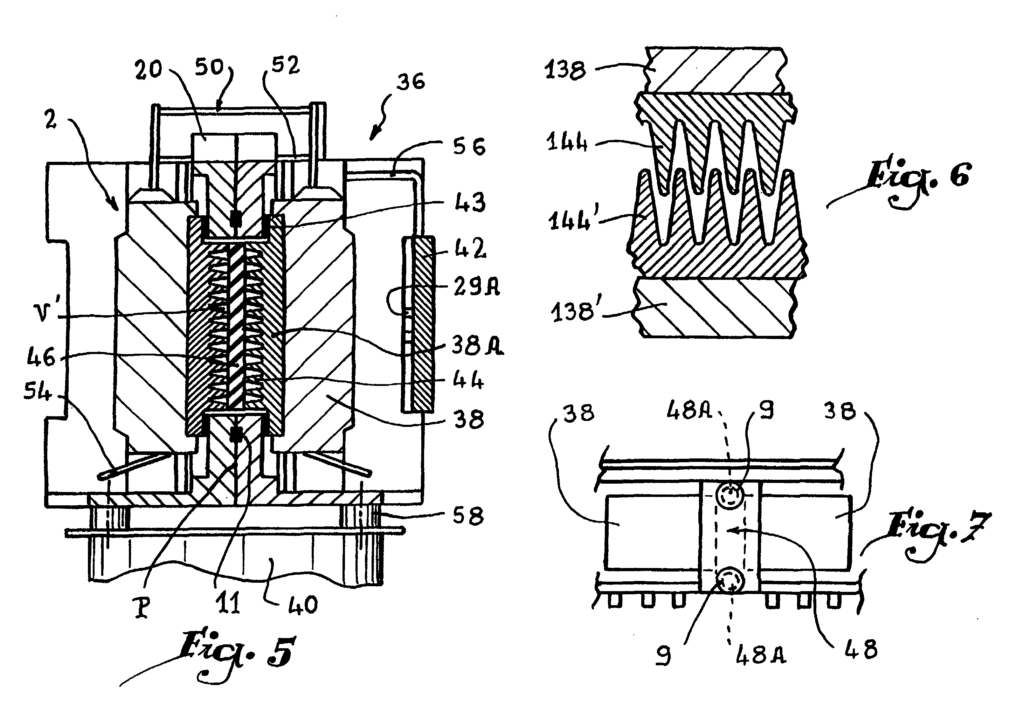

La figure 4 représente une phase d'onduleur, désignée dans son ensemble par la référence 36, formée à partir de l'élément de refroidissement des figures 1 à 3 une fois assemblé. Cette phase 36 comprend des modules de puissance 38 rapportés au niveau de chaque ouverture 28 dont est pourvu l'élément de refroidissement 2. Ce dernier supporte également des allumeurs 40, des condensateurs 41 et une barre de phase 42.

De manière plus précise et en se référant en particulier à la figure 5, chaque module de puissance 38, qui est par exemple un transistor bipolaire à grille isolée dit IGBT, comprend une embase 38A réalisée par exemple en cuivre. Cette dernière prend appui sur la périphérie intérieure de l'une des plages 24, avec interposition d'un joint d'étanchéité 43. Des moyens d'étanchéité peuvent être également constitués par une coopération de formes intime entre le module et l'ouverture qui le reçoit, par exemple dans le cas où le matériau de l'élément de refroidissement est surmoulé autour du module.

L'embase 38A est munie, à son extrémité opposée au corps du module 38, d'ailettes 44 pénétrant dans le volume de circulation V, à travers chaque ouverture 28. Deux modules de puissance identiques sont prévus et se font face, de part et d'autre d'un plan (P) médian de l'élément de refroidissement. Chaque plage 24 forme ainsi siège de réception de l'embase 38A d'un module de puissance 38 correspondant.

Un insert 46, réalisé par exemple en mousse ou en silicone, est bloqué entre les extrémités adjacentes des ailettes 44 de chaque module de puissance 38. Un tel agencement permet de s'affranchir de la présence de débit d'eau parasite contournant les ailettes 44, de sorte que l'échange de chaleur est optimal au niveau de ces dernières. En effet, le fluide caloporteur est contraint de se déplacer au niveau des volumes interstitiels V' formés entre chaque couple d'ailettes voisines d'un même module de puissance.

On peut également prévoir, comme le montre la figure 6, que les ailettes 144 d'un premier module de puissance 138, s'étendent au-delà de l'extrémité des ailettes 144' du module 138' disposé en regard. Cette disposition garantit également un échange de chaleur maximal.

La fixation des modules de puissance 38 sur l'élément de refroidissement 2 est illustrée à la figure 7. Deux modules 38 successifs, rapportés sur le même demi-corps 2A, sont fixés au moyen d'une unique bride 48 recouvrant les extrémités en regard de ces deux modules. Cette bride 48, réalisée en matériau électriquement conducteur, est elle-même fixée au demi-corps 2A par l'intermédiaire des vis 9 qui assurent également l'assujettissement mutuel des deux demi-corps. Ces vis 9 pénètrent dans des trous 48A percés au sein de la bride dans le prolongement des trous 8 ménagés au sein de chaque demi-corps 2A, 2B.

En faisant à nouveau référence à la figure 5, les deux modules de puissance 38 se faisant face sont connectés électriquement au moyen d'organes conducteurs 50 étayés par des entretoises 52 prenant appui sur les saillies 20 de chaque bordure 18. La commande des modules de puissance est assurée par exemple par des fils torsadés venant se connecter sur des organes conducteurs 54.

La barre de phase 42 est fixée à l'élément de refroidissement 2 par l'intermédiaire des pions 29A dont est muni ce dernier, pions qui pénètrent dans des orifices correspondants de la barre de phase. Cette dernière est reliée électriquement à un ou plusieurs modules de puissance 38 au moyen d'un élément conducteur 56.

Les allumeurs 40 sont assujettis à l'élément de refroidissement 2, au niveau des bordures 18 de chaque demi-corps 2A, 2B. Cette fixation est assurée par l'intermédiaire de bossages 58 venus de matière avec l'élément de refroidissement.

L'invention permet de réaliser les objectifs précédemment mentionnés. En effet, l'élément de refroidissement réalisé en matière isolante et pourvu d'ouvertures de réception des modules de puissance, assume une triple fonction de support mécanique, de refroidissement et d'isolation électrique.

On peut donc assembler sur cet élément de refroidissement des ensembles devant être isolés mutuellement, sans avoir recours aux montages mécaniques complexes connus dé l'art antérieur.

L'élément de refroidissement de l'invention est donc d'une conception beaucoup plus simple et présente un volume notablement réduit par rapport aux éléments de refroidissement de l'art antérieur, cette réduction pouvant être estimée entre 30 et 50%. De plus, l'utilisation d'une matière isolante permet de réduire la masse globale de l'élément de refroidissement, en comparaison avec l'emploi d'une matière conductrice métallique.

Faire appel à un matériau moulable permet de réaliser de manière extrêmement simple l'ensemble des formes complexes nécessaires à la réalisation des fonctions qu'assure l'élément de refroidissement de l'invention, par exemple les bossages 58. De plus, l'ensemble de ces fonctions peut être assuré au niveau d'une pièce unique.

Le fait d'assembler deux demi-corps l'un à l'autre pour réaliser l'élément de refroidissement conforme à l'invention garantit un moulage aisé, en particulier lorsque ces demi-corps sont identiques.

L'emploi de modules de puissance fixés directement au niveau des ouvertures des éléments de refroidissement assure un contact direct entre ce module de puissance et le fluide caloporteur, de sorte qu'il est possible d'employer un volume de silicium réduit par rapport à celui utilisé dans l'art antérieur, ce qui induit un gain économique d'environ 30% au niveau de chaque module de puissance.

La fixation de deux modules de puissance voisins par l'intermédiaire d'un organe de bridage commun permet d'utiliser un nombre d'éléments de fixation sensiblement réduit par rapport à l'art antérieur. De plus, l'emploi d'un tel organe de bridage commun réalisé en matériau conducteur permet de mettre au même potentiel les deux modules voisins. Etant donné qu'il est fait appel à un nombre réduit d'organes de fixation, il est possible de disposer un nombre de modules de puissance plus élevé que dans l'art antérieur sans pour autant augmenter les coûts de montage, de sorte que la phase d'onduleur ainsi réalisée possède une modularité et une compacité supérieures à celles des phases de l'art antérieur. La réduction du nombre d'organes de fixation employés est tout particulièrement sensible dans le cas où, s'agissant d'un élément de refroidissement réalisé en deux demi-corps, les mêmes organes de fixation assurent à la fois l'assujettissement mutuel de ces deux demi-corps et la fixation de chaque organe de bridage sur chaque demi-corps respectif.

On peut également prévoir que les modules de puissance soient fixés sur au moins une plaque rapportée au niveau d'une ou plusieurs ouvertures dont est pourvu l'élément de refroidissement. Il est par exemple possible de faire appel à une unique plaque conductrice sur laquelle sont rapportés différents modules de puissance qui sont, de ce fait, mis au même potentiel, ce qui permet d'employer des modules de puissance standards. On peut également utiliser plusieurs plaques isolantes sur chacune desquelles est fixé un module de puissance correspondant, ce qui permet d'isoler ces différents modules entre eux.

L'emploi d'une ou plusieurs de telles plaques permet d'utiliser les moyens de fixation de l'art antérieur, tout en tirant parti des avantages d'un élément de refroidissement en matériau électriquement isolant.

## Revendications

1. Dispositif électronique de puissance, notamment phase d'onduleur (36), comportant un élément de refroidissement (2), plusieurs modules de puissance (38) fixés sur ledit élément de refroidissement et des fonctions complémentaires dudit dispositif, notamment des allumeurs (40), ledit élément de refroidissement (2) étant réalisé en un matériau électriquement isolant et comprenant des moyens d'amenée et d'évacuation (29) d'un fluide caloporteur, un volume intérieur de circulation (V) dudit fluide, et au moins une ouverture (28) mettant en communication ledit volume intérieur (V) avec l'extérieur dudit élément, un pourtour (24) de chaque ouverture (28) formant siège de réception, avec interposition de moyens d'étanchéité (43), d'une embase (38A) de chaque module de puissance (38), **caractérisé en ce que** les modules de puissance (38) sont fixés par paires, au niveau d'ouvertures (28) correspondantes disposées de façon symétrique par rapport au plan médian (P) de l'élément de refroidissement (2)

2. Dispositif électronique de puissance selon la revendication 1, **caractérisé en ce qu'**un insert (46) est bloqué entre les extrémités voisines de chaque paire de modules (38) se faisant face.

3. Dispositif électronique de puissance selon la revendication 1, **caractérisé en ce que** l'extrémité (144) d'un premier module (138) s'étend, en direction d'un second module (138') lui faisant face, au niveau ou au-delà de l'extrémité (144') de ce dernier.

4. Dispositif électronique de puissance selon l'une des revendications 1 à 3, **caractérisé en ce que** chaque embase (38A) reçue sur le pourtour (24) de chaque ouverture (28) est réalisée de manière monobloc avec un desdits modules de puissance (38).

5. Dispositif électronique de puissance selon la revendication 4, **caractérisé en ce que** ladite embase (38A) comporte des ailettes (44) s'étendant selon la direction d'écoulement du fluide.

6. Dispositif électronique de puissance selon l'une des revendications précédentes, **caractérisé en ce que** lesdits modules de puissance (38) sont fixés sur ledit élément de refroidissement par un organe de bridage (48), au niveau de leur face opposée au volume intérieur de circulation (V) du fluide.

7. Dispositif électronique selon la revendication 6, **caractérisé en ce que** ledit organe de bridage (48) est électriquement conducteur et se trouve commun à deux modules de puissance (38) voisins disposés selon la direction d'écoulement de fluide.

8. Dispositif électronique selon l'une des revendications 6 ou 7, **caractérisé en ce que** ledit élément de refroidissement (2) comprend deux demi-corps (2A, 2B) assemblés l'un à l'autre, et ledit organe de bridage (48) est fixé audit élément de refroidissement (2) par des moyens de fixation (9) assurant également l'assujettissement mutuel desdits deux demi-corps (2A, 2B).

9. Dispositif électronique de puissance selon l'une des revendications précédentes, **caractérisé en ce que** l'élément de refroidissement (2) est réalisé en un matériau moulable.

10. Dispositif électronique de puissance selon l'une des revendications précédentes, **caractérisé en ce que** l'élément de refroidissement (2) comprend deux demi-corps (2A, 2B) identiques, assemblés l'un à l'autre.

11. Dispositif électronique de puissance selon l'une des revendications précédentes, **caractérisé en ce que** l'espace intermédiaire séparant deux ouvertures (28) voisines, placées dans la direction d'écoulement du fluide, comporte au moins deux canaux (30) s'étendant selon la direction d'écoulement du fluide, lesdits canaux (30) étant séparés par au moins une nervure (32) dont est pourvu ledit élément de refroidissement (2).

12. Dispositif électronique de puissance selon la revendication 11, **caractérisé en ce que** l'axe longitudinal de ladite nervure (32) est incliné par rapport à la direction d'écoulement du fluide.

## Claims

1. A power electronic device, in particular an inverter phase (36), comprising a cooling element (2), a plurality of power modules (38) fixed to said cooling element and complementary functions of said device, in particular starters (40), said cooling element (2) being made from an electrically insulative material and comprising heat-exchange fluid inlet and outlet means (29), an interior volume (V) in which said fluid circulates, and at least one opening (28) connecting said internal volume (V) to the exterior of said element, a perimeter (24) of each opening (28) forming a seat receiving a base (38A) of each power module (38) with sealing means (43) between them, the device being **characterized in that** the power modules (38) are fixed in pairs at corresponding openings (28) disposed symmetrically with respect to the median plane (P) of the cooling element (2).

2. A power electronic device according to claim 1, **characterized in that** an insert (46) is immobilized between the adjacent ends of the facing modules (38) of each pair.

3. A power electronic device according to claim 1, **characterized in that** the end (144) of a first module (138) extends towards a second module (138') facing it at or beyond the end (144') of the latter.

4. A power electronic device according to any one of claims 1 to 3, **characterized in that** each base (38A) received on the perimeter (24) of each opening (28) is integral with one of said power modules (38).

5. A power electronic device according to claim 4, **characterized in that** said base (38A) has fins (44) extending in the fluid flow direction.

6. A power electronic device according to any preceding claim, **characterized in that** said power modules (38) are fixed to said cooling element by a clamp (48) on their face opposite the interior fluid circulation volume (V).

7. The electronic device according to claim 6, **characterized in that** said clamp (48) is electrically conductive and is common to two power modules (38) which are adjacent in the fluid flow direction.

8. An electronic device according to claim 6 or claim 7, **characterized in that** said cooling element (2) comprises two half-bodies (2A, 2B) assembled together and said clamp member (48) is fixed to said cooling element (2) by fixing means (9) which also fasten said two half-bodies (2A, 2B) together.

9. A power electronic device according to any preceding claim, **characterized in that** the cooling element (2) is made from a material that can be molded.

10. A power electronic device according to any preceding claim, **characterized in that** the cooling element (2) comprises two identical half-bodies (2A, 2B) assembled together.

11. A power electronic device according to any preceding claim, **characterized in that** the intermediate space between two openings (28) which are adjacent in the fluid flow direction includes at least two passages (30) extending in the fluid flow direction and separated by at least one rib (32) on said cooling element (2).

12. A power electronic device according to claim 11, **characterized in that** the longitudinal axis of said rib (32) is inclined to the fluid flow direction.

## Patentansprüche

1. Elektronische Leistungsvorrichtung, insbesondere Undulatorphase (36), enthaltend ein Kühlelement (2), mehrere, auf dem Kühlelement befestigte Leistungsmodule (38) und Komplementärfunktionen der Vorrichtung, insbesondere die Zünder (40), wobei das Kühlelement (2) aus einem elektrisch isolierenden Material hergestellt ist und Zuführund Abführeinrichtungen (29) für ein Wärmetransportfluid aufweist, ein Zirkulationsinnenvolumen (V) des Fluides und mindestens eine Öffnung (28), die die Verbindung zwischen dem Innenvolumen (V) und dem Äußeren des Elements herstellt, einen äußeren Umfang (24) einer jeden Öffnung (28), der eine Aufnahmefassung bildet, mit Zwischenlagerung von Dichtungsmitteln (43), eine Befestigungsfläche (38A) für jedes Leistungsmodul (38), **dadurch gekennzeichnet, daß** die Leistungsmodule (38) paarweise auf Höhe der entsprechenden Öffnungen (28) befestigt sind, die bezüglich der Mittelebene (P) des Kühlelements (2) symmetrisch angeordnet sind.

2. Elektronische Leistungsvorrichtung nach Anspruch 1, **dadurch gekennzeichnet, daß** ein Einsatz (46) zwischen den benachbarten Extremitäten eines jeden Paares sich gegenüberliegender Module (38) fest sitzt.

3. Elektronische Leistungsvorrichtung nach Anspruch 1, **dadurch gekennzeichnet, daß** die Extremität (144) eines ersten Moduls (138) in Richtung eines zweiten, ihm gegenüberliegenden Moduls (138') bis zur Extremität (144') von letzterem oder darüber hinaus verläuft.

4. Elektronische Leistungsvorrichtung nach einem der Ansprüche 1 bis 3, **dadurch gekennzeichnet, daß** jede auf dem äußeren Umfang (24) von jeder Öffnung (28) untergebrachte Befestigungsfläche (38A) aus einem Stück mit einem der Leistungsmodule (38) hergestellt ist.

5. Elektronische Leistungsvorrichtung nach Anspruch 4, **dadurch gekennzeichnet, daß** die Befestigungsfläche (38A) Rippen (44) aufweist, die in Fließrichtung des Fluides verlaufen.

6. Elektronische Leistungsvorrichtung nach einem der vorhergehenden Ansprüche, **dadurch gekennzeichnet, daß** die Leistungsmodule (38) an ihrer dem Zirkulationsinnenvolumen (V) des Fluides gegenüberliegenden Fläche über ein Flanschorgan (48) an dem Kühlelement befestigt sind.

7. Elektronische Vorrichtung nach Anspruch 6, **dadurch gekennzeichnet, daß** das Flanschorgan (48) elektrisch leitend und zwei benachbarten, in Fließrichtung des Fluides angeordneten Leistungsmodulen (38) gemeinsam ist.

8. Elektronische Vorrichtung nach einem der Ansprüche 6 oder 7, **dadurch gekennzeichnet, daß** das Kühlelement (2) zwei gegenseitig zusammengefügte Halbkörper (2A, 2B) aufweist und das Flanschorgan (48) an dem Kühlelement (2) über Befestigungsmittel (9), die auch die gegenseitige Verbindung der beiden Halbkörper (2A, 2B) sicherstellen, befestigt ist.

9. Elektronische Leistungsvorrichtung nach einem der vorhergehenden Ansprüche, **dadurch gekennzeichnet, daß** das Kühlelement (2) aus einem formbaren Material hergestellt ist.

10. Elektronische Leistungsvorrichtung nach einem der vorhergehenden Ansprüche, **dadurch gekennzeichnet, daß** das Kühlelement (2) zwei identische, miteinander zusammengefügte Halbkörper (2A, 2B) aufweist.

11. Elektronische Leistungsvorrichtung nach einem der vorhergehenden Ansprüche, **dadurch gekennzeichnet, daß** der Zwischenraum, der zwei benachbarte, in Fließrichtung des Fluides angeordnete Öffnungen (28) trennt, mindestens zwei Kanäle (30) aufweist, die in Fließrichtung des Fluides verlaufen, wobei die Kanäle (30) durch mindestens eine Rippe (32), womit das Kühlelement (2) ausgestattet ist, getrennt sind.

12. Elektronische Leistungsvorrichtung nach Anspruch 11, **dadurch gekennzeichnet, daß** die Längsachse der Rippe (32) bezüglich der Fließrichtung des Fluides geneigt ist.
